# EUROPEAN PATENT SPECIFICATION

(11) **EP 1 096 516 B1**
(45) Date of publication and mention of the grant of the patent: **11.08.2004**
(21) Application number: 00122307.2
(22) Date of filing: 20.10.2000
(51) Int. Cl.: H01F 27/29

(54) **Low profile inductive component**
Niedrigprofil-Induktivkomponente
Composant inductif de faible profil

(30) Priority: 28.10.1999 US 428904
(43) Date of publication of application: 02.05.2001
(73) Proprietor: COILCRAFT, INC., Cary, IL 60013 (US)
(72) Inventor: Boytor, James G., Crystal Lake, ILL 60014 (US); Girbaci, Catalin C., Cary, ILL 60013 (US); Gogny, Helen O., McHenry, ILL 60050 (US)
(74) Representative: HOFFMANN - EITLE

(56) References cited:
- US-A- 5 307 041
- US-A- 5 760 669
- PATENT ABSTRACTS OF JAPAN vol. 1996, no. 02, 29 February 1996 (1996-02-29) & JP 07 288210 A (TDK CORP), 31 October 1995 (1995-10-31)
- PATENT ABSTRACTS OF JAPAN vol. 1999, no. 05, 31 May 1999 (1999-05-31) & JP 11 054345 A (HITACHI FERRITE ELECTRONICS LTD), 26 February 1999 (1999-02-26)

## Description

### FIELD OF THE INVENTION

This invention relates generally to electronic components, and more particularly concerns low profile surface mountable inductive components.

### BACKGROUND

The electronics industry is continually called upon to make products smaller and more powerful. Applications such as mobile phones, portable computers, computer accessories, hand-held electronics, etc., create a large demand for smaller electrical components. These applications further drive technology to research new areas and ideas with respect to miniaturizing electronics. Often times, applications specifically require "low profile" components due to constraints in height and width. Unfortunately, the technology is often limited due to the inability to make certain components smaller, faster, or more powerful. Nowhere can this be seen more than in the struggle to manufacture smaller electrical circuits.

Originally, components were mounted on a printed circuit board (PCB) by inserting the leads of the component through the PCB and soldering them to solder pads on the opposite side of the PCB, (called through-hole technology). This technique left half of the PCB unpopulated because one side had to be reserved for solder pads and solder. Therefore, in order to fit more components in a particular circuit, the PCBs were made larger, or additional PCBs were required.

The solution to this problem came in the form of Surface-Mount Devices (SMD), or Surface-Mount Technology. SMDs allow electrical components to be mounted on one side of a PCB, (i.e., without having the leads inserted through-holes). An SMD device has small solder pads (or leads) connected to its body, which correspond to solder pads or lands placed on the surface of the PCB. Typically the PCB is run through a solder-paste machine (or screen printer), which puts a small amount of solder on the solder pads on the PCB. Next, a glue dot is inserted on the PCB where the component is to rest. Then, the component is placed on the PCB (held by the glue dot), and the PCB is sent through a re-flow oven to heat the solder paste and solder the component leads to the PCB solder pads. The primary advantage to this technique is that both sides of the PCB can now be populated by electronic components. Meaning one PCB today can hold an amount of electrical components equal to two PCBs in the past.

As a result of this advancement in technology, the current electronic circuits are mainly limited by the size of components used on the PCB. Meaning, if the electronic components are made smaller, the circuits are smaller as well. Unfortunately, there are some electronic components that can simply not be produced any smaller than they currently are. Usually this is because the desired parameters for the component cannot be achieved when using smaller parts. A good example of this is inductive components. Inductive components are often used in stepper motors, transformers, servos, relays, inductors, antennas, etc. Typical applications requiring such components include radio frequency (RF), switching power supplies, converters, data communications, processor/controller circuits, signal conditioning circuits, biasing oscillators, DC-DC converters, DC-AC converters, chokes, IC inverters, filters, etc. Certain parameters of these components are affected by the size of parts used. For instance, in inductors, wire gauge determines both the DC resistance and the current carrying ability of the component.

Several attempts have been made to compensate for components requiring a minimum amount of size in order to use them in smaller circuit applications. For example, U.S. Patent No. 5,760,669, issued June 2, 1998, to Dangler et al., discloses a low profile inductor/transformer component having a wire coil within a core set which is disposed at least partially within a recess in a header. To achieve its low profile status, Dangler uses a header with a plurality of projections extending from the header's side. A core set is disposed within the header and a pre-wound coil is inserted around the core set. At least one end of the pre-wound coil is wrapped around at least one of the header projections, thereby increasing the size of the coil without raising the height of the component. Unfortunately, this structure creates an awkward sized component with exposed conductive wires capable of being damaged. In addition, the need for pre-wound coils, upper and lower core attachments (the core set), and a header having projections is costly and takes up valuable space on the PCB. Such a device does not answer the growing need for smaller components.

Another attempt to produce low profile surface mount coil assemblies is disclosed in U.S. Patent No. 5,796,324, issued August 18, 1998, to Ross et al. Ross discloses a coil wound bobbin having posts that are capable of suspending the coil either above or alongside a PCB. The ends of the coil wire are wrapped on the posts to form wire terminations. These posts are the only part of the component that need to be soldered to the PCB. Unfortunately, suspending the coil above or alongside the PCB does not reduce the amount of space required for the circuit as a whole. Suspending the wire above the board simply raises the height of the circuit. Suspending the coil alongside the PCB raises the width requirement for the circuit.

Relevant to potentability of the claims below is another coil component disclosed in U.S. Patent No. 5,307,041, issued April 26, 1994, to Kato et al. Kato discloses a coil component having a ring shaped housing (5) connected to a rectangular support (1) having terminals (2b) for connecting the component to a PCB. More specifically a body is disclosed which has separate legs extending from the body and defining an aperture extending through the body between the legs, as well as a core having an end portion disposed in the aperture and an opposite end portion extending from the body between the legs, and a wire wound around the core. The need for an additional base portion, such as rectangular support (1), increases the height of the component, and therefore, will not satisfy the growing need for smaller components.

Accordingly, it has been determined that the need exists for an improved low profile inductive component which overcomes the aforementioned limitations and which further provides capabilities, features and functions, not available in current devices.

### SUMMARY OF THE INVENTION

A low profile inductive component in accordance with the invention comprises the features as claimed in claim 1.

In an embodiment, the body is constructed such that a lower flange of the core extends beyond the solder pads so that when mounted on a printed circuit board the lower flange extends into an aperture in the PCB. With such a construction, the height of the inductive component above the board will be lower than the height of the prior described embodiment.

An advantage to using this component is that the wire wound around the core is not exposed and the inductive component takes on a slim wafer shape, making it ideal for low profile applications. A further advantage is that the component retains a traditional shape and has no awkward protruding members, thereby making it suitable for vacuum placement surface mount applications, for densely populated PCBs, and/or applications requiring components that use a minimal amount of space.

### BRIEF DESCRIPTION OF THE DRAWINGS

Other objects and advantages of the invention will become apparent upon reading the following detailed description and upon reference to the drawings, in which:
Figure 1 is an exploded view of a low profile inductive component according to the invention;
Figure 2 is a profile view, partially in a cross-section, of the component shown in Figure 1 mounted on a printed circuit board;
Figure 3a is a profile view, partially in a cross-section, of another embodiment of a low profile inductive component according to the invention mounted on a printed circuit board; and
Figure 3b is a profile view of the component shown in Figure 3a mounted on a printed circuit board.

### DETAILED DESCRIPTION OF THE INVENTION

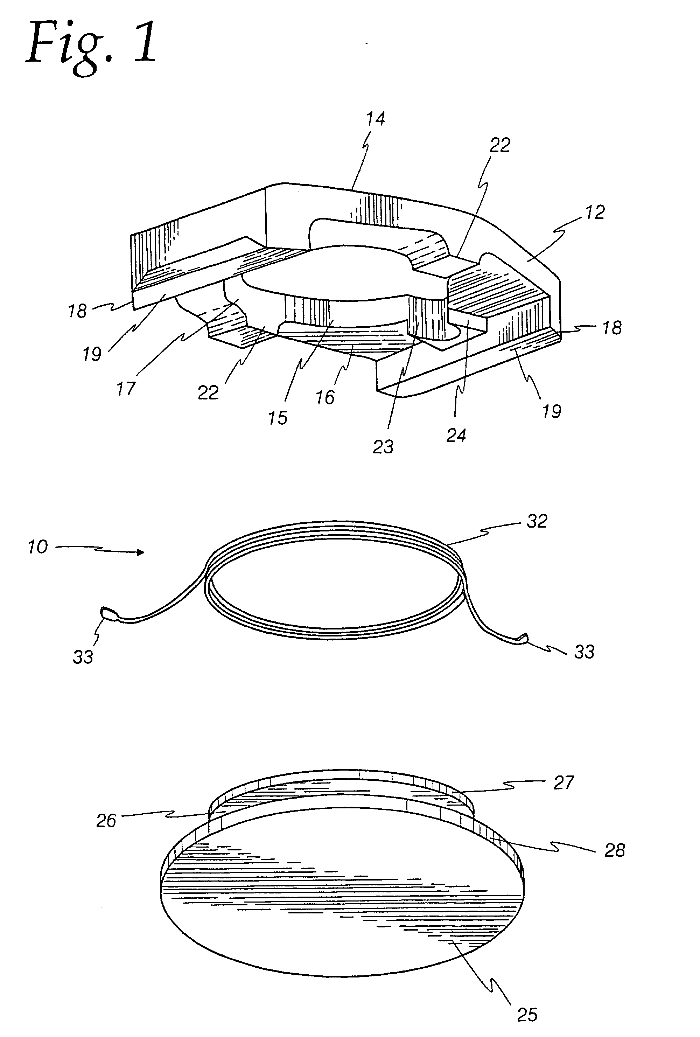

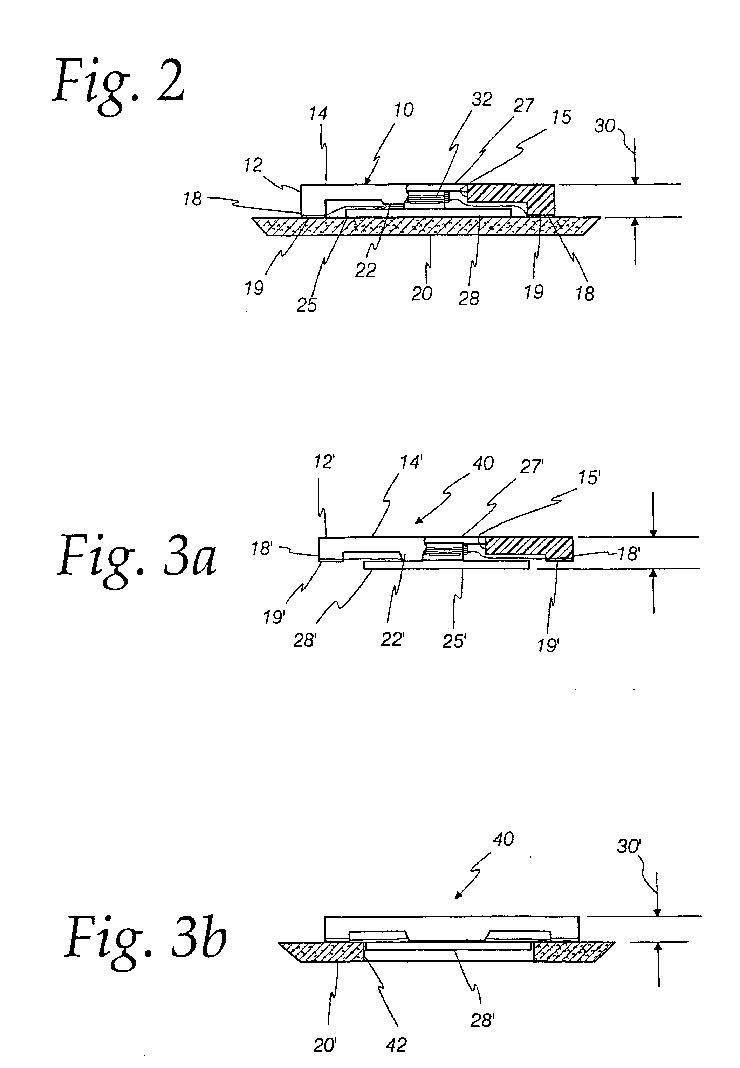

Turning first to Figs. 1 and 2, a low profile inductive component in accordance with the invention for mounting above the printed circuit board (PCB) is shown generally at reference numeral 10. For convenience, the inductive component is described as it would be positioned on the upper surface of a PCB.

In Figs. 1 and 2, the low profile inductive component 10 includes a low profile body 12 made of an insulating material, such as a non-conductive plastic or ceramic. The body 12 has a polygonal shape, such as a hexagon, and is defined by a smooth planer top 14 and a bottom 16. The body 12 defines an aperture 15 passing directly through the center of the top 14 and the bottom 16, and having an inner wall 17.

A pair of legs 18 extend downward from opposite ends of the body 12. Soldering pads are located at the bottom of the legs 18, which are made of a conductive material, such as metal, for electrically and mechanically attaching the low profile inductive component 10 to a PCB 20. As is depicted in Fig. 1, each soldering pad 19 is L-shaped and covers the bottom of the associated leg 18 and a part of its outer side. This configuration allows for the inductive component 10 to be removed with a standard soldering iron.

The bottom 16 of the body also includes a pair of integrated spacers 22 extending downwards from the body 12 adjacent the aperture in a plane perpendicular to the planes containing the legs 18.

The inner wall 17 of the aperture 15 includes a pair of opposed recesses 23, which are generally arched-shaped and extend perpendicular to the planes containing the legs 18. The bottom 16 of the body 12 extends down around the perimeter of each recess 23, thereby creating a recess-shaped spacer 24. The recesses 23 aid in the positioning of the inductive component 10 on the PCB.

The low profile inductive component 10 further includes a core 25 of magnetic material, such as ferrites, having a cylindrical center section 26 with an upper flange 27 on the upper end of the center section 26 and a larger diameter lower flange 28 on the lower end of the center section 26. The core 25 is disposed in the aperture 15 with the upper flange 27 fitting snugly in the aperture 15 and with upper surface of the lower flange abutting the spacers 22 and 24. The core 25 may be affixed to the spacers 22 and 24 by a suitable glue. The spacers 22 and 24, and the core 25 are sized so that the top of the upper flange 27 is about even with the top surface 14 of the body 12 and the lower surface of the lower flange is in about the same plane as the solder pads 18. In other words, the core 25 fits completely within the body 12.

The inductive component 10 also includes an insulated electric wire 32, such as 24 gage copper wire, wound around the center section of the core 14 and having ends 33 connected to the bottom of the soldering pads 19. The ends 33 and 56 are press fit against the soldering pads 19 to ensure that the ends will be soldered to the lands on the PCB 22.

The height of the component 10, as indicated in Fig. 2 with the reference numeral 30, when mounted on the PCB is less than about 1.65 mm above the PCB.

In Figs. 3a-b, a low profile inductive component for mounting partially in the PCB is shown generally at reference numeral 40. This component is similar to the component shown in Figs. 1 and 2, and the similar parts are identified with the same reference numeral with exponent " ' ".

In this embodiment, the legs 18' of the body 12' are made shorter so that the lower flange 28' extends below the plane of the solder pads 19'. As shown in Fig. 3b, the printed circuit board 20 is provided with an aperture 42 that is larger than the diameter of the lower flange 28'. The aperture 42 is positioned between the lands on the PCB so that when the component 40 is mounted on the PCB, the lower flange 28' extends into the aperture.

The height of the component when mounted in the PCB is less than the component of Figs.1 and 2. Its height 30' is less than about 1.19 mm.

Thus, in accordance with the present invention, a low profile inductive component is provided that fully satisfies the objects, aims, and advantages set forth above. While the invention has been described in conjunction with specific embodiments thereof, it is evident that many alternatives, modifications, and variations will be apparent to those skilled in the art in light of the foregoing description.

## Claims

1. An inductive component (10) for mounting on a printed circuit board (20) comprising:
a low profile body (12) having spaced apart soldering pads (19) connected thereto for electrically and mechanically attaching said body (12) to lands on a printed circuit board (20), and defining an aperture (15) extending through said body (12) between said soldering pads (19);
a core (25) having first and second ends and having at least a portion of the core (25) disposed in said aperture (15); and
a wire (32) wound around said core (25) having first and second ends (33) electrically connected to respective soldering pads (19).

2. An inductive component in accordance with claim 1, wherein said core (25) is comprised of a magnetic material.

3. An inductive component in accordance with claim 1, wherein said first and second core ends comprise first and second flanged ends (27, 28), respectively, and said second flanged end (28) extends from said body (12) between said soldering pads (19).

4. An inductive component in accordance with claim 1, wherein said first and second core ends comprise first and second flanged ends (27, 28), respectively, and said second flanged end (28) extends from said body (12) beyond said soldering pads (19).

5. An inductive component in accordance with claim 1, wherein said first and second core ends comprise first and second flanged ends (27, 28), respectively, and said second flanged end (28) extends from said body (12) an amount no greater than the amount said solder pads (19) extend from said body (12).

6. An inductive component in accordance with claim 1, wherein said first and second core ends comprise first and second flanged ends (27, 28), respectively, and said second flanged end (28) extends from said body (12) an amount greater than the amount said solder pads (19) extend from said body (12).

7. An inductive component in accordance with claim 6, wherein said second flanged end (28) extends from said body (12) and into an aperture (42) in the printed circuit board (20) an amount no greater than the thickness of the printed circuit board (20).

8. An inductive component in accordance with claim 1, wherein said first and second core ends comprise first and second flanged ends (27, 28), respectively, and said first flanged end (27) is disposed in said aperture (15) of said body (12) such that said first flanged end (27) and said body (12) create a generally planar top surface.

9. An inductive component in accordance with claim 1, wherein said first and second core ends comprise first and second flanged ends (27, 28), respectively, and said second flanged end (28) extends from said body (12) to about the plane containing said soldering pad (19).

10. An inductive component in accordance with claim 1, wherein said first and second core ends comprise first and second flanged ends (27, 28), respectively, and said first flanged end (27) is smaller in diameter than said second flanged end (28).

11. An inductive component in accordance with claim 10, wherein said firs flanged end (27) is disposed in said aperture (15) above said second flanged end (28).

12. An inductive component in accordance with claim 10, wherein said inductive component (10) is of a height of less than about 1.65 mm.

13. An inductive component in accordance with claim 1, wherein said inductive component (10) is of a height of less than about 1.65 mm.

14. An inductive component in accordance with claim 1, wherein the core (25) has a reduced diameter central section (26) on which the wire is wound and said first and second core ends comprise first and second flanged ends (27, 28), respectively, wherein the first flanged end (27) fits snugly in the aperture (15) and the second flanged end (28), of larger diameter than the first flanged end (27), is spaced from the surface of the body (12) by spacers (22) extending from the lower surface of said body (12).

15. An inductive component in accordance with claim 12, wherein the spacers (22) are of a height to position the second flange (28) about even with the plane of the solder pads (19).

16. An inductive component in accordance with claim 1, wherein said low profile body (12) has spaced apart legs (18) extending from said body about said aperture (15); and said soldering pads (19) are connected to said legs (18).

17. An inductive component in accordance with claim 1, wherein said low profile body (12) has legs (18) extending from said body (12) to which said soldering pads (19) are connected.

18. An inductive component in accordance with claim 17, wherein said low profile body (12) is polygonal in shape and has a height of less than about 1.65 mm.

19. A method of making a low profile inductive component (10) to be placed on a printed circuit board (20), wherein the method comprises:
providing a low profile body (12) having spaced apart soldering pads (19) connected thereto and defining an aperture (15) extending through said body (12);
providing a core (25);
wrapping a wire (32) around said core (25) so as to provide first and second ends (33);
inserting at least a portion of said core (25) into said aperture (15); and
electrically connecting said wire ends (33) to respective soldering pads (19) on said body (12).

20. A method of making a low profile inductive component (10) in accordance with claim 19, wherein providing a low profile body (12) comprises providing a low profile body (12) having spaced apart legs (18) to which the soldering pads (19) are connected.

21. A method of mounting a low profile inductive component (10) on a printed circuit board (20), comprising the steps of:
providing a low profile body (12) having spaced apart soldering pads (19) extending from said body (12) and defining an aperture (15) extending through said body (12) between said soldering pads (19);
providing a core (25) having first and second end portions (27, 28) and having at least a portion of the core disposed in said aperture (15);
providing a wire (32) wound around said core (25) and having first and second ends (33) connected to respective soldering pads (19);
inserting said low profile inductive component (10) on said printed circuit board (20) such that said soldering pads (19) abut lands on the printed circuit board (20); and
soldering said low profile inductive component (10) to said lands to electrically and mechanically attach said component (10) to the printed circuit board (20).

22. The method of claim 21, wherein one of said core ends (27, 28) extends from said body (12) between said soldering pads (19) and further comprises the step of inserting the extending core end (27, 28) into an aperture (42) in said printed circuit board (20).

23. The method of claim 22, wherein inserting the extending core end (27, 28) into the aperture (42) comprises extending the core end (27, 28) into the aperture (42) an amount no greater than the thickness of the printed circuit board (20).

## Patentansprüche

1. Induktive Komponente (10) zur Anbringung an einer Platine (20), mit:
einem Körper (12) mit niedrigem Profil, mit dem beabstandete Lötkissen (19) verbunden sind, um den Körper (12) elektrisch und mechanisch an Flächen auf einer Platine (20) anzubringen, wobei sich eine Öffnung (15) durch den Körper (12) hindurch zwischen diesen Lötkissen (19) erstreckt;
einem Kern (25) mit einem ersten und einem zweiten Ende, wobei sich zumindest ein Bereich des Kerns (25) in der Öffnung (15) befindet; und
einem Draht (32), der um den Kern (25) herum gewickelt ist und ein erstes und ein zweites Ende (33) hat, die elektrisch mit jeweiligen Lötkissen (19) verbunden sind.

2. Induktive Komponente nach Anspruch 1, wobei der Kern (25) aus einem magnetischen Material besteht.

3. Induktive Komponente nach Anspruch 1, wobei das erste und das zweite Ende des Kerns ein erstes bzw. zweites geflanschtes Ende (27, 28) aufweisen und das zweite geflanschte Ende (28) sich von dem Körper (12) aus zwischen den Lötkissen (19) erstreckt.

4. Induktive Komponente nach Anspruch 1, wobei das erste und das zweite Ende des Kerns ein erstes bzw. ein zweites geflanschtes Ende (27, 28) aufweisen und das zweite geflanschte Ende (28) sich von dem Körper (12) aus nach jenseits der Lötkissen (19) erstreckt.

5. Induktive Komponente nach Anspruch 1, wobei das erste und das zweite Ende des Kerns ein erstes bzw. ein zweites geflanschtes Ende (27, 28) aufweisen und das zweite geflanschte Ende (28) sich von dem Körper (12) aus um einen Betrag erstreckt, der nicht größer als der Betrag ist, um den sich die Lötkissen (19) von dem Körper (12) aus erstrecken.

6. Induktive Komponente nach Anspruch 1, wobei das erste und das zweite Ende des Kerns ein erstes bzw. ein zweites geflanschtes Ende (27, 28) aufweisen und das zweite geflanschte Ende (28) sich von dem Körper (12) aus um einen Betrag erstreckt, der größer als der Betrag ist, um den sich die Lötkissen (19) von dem Körper (12) aus erstrecken.

7. Induktive Komponente nach Anspruch 6, wobei das zweite geflanschte Ende (28) sich von dem Körper (12) aus und in eine Öffnung (42) in der Platine (20) hinein um einen Betrag erstreckt, der nicht größer ist als die Dicke der Platine (20).

8. Induktive Komponente nach Anspruch 1, wobei das erste und das zweite Ende des Kerns ein erstes bzw. ein zweites geflanschtes Ende (27, 28) aufweisen und das erste geflanschte Ende (27) in der Öffnung (15) des Körpers (12) so vorgesehen ist, dass das erste geflanschte Ende (27) und der Körper (12) eine im Wesentlichen ebene obere Fläche bilden.

9. Induktive Komponente nach Anspruch 1, wobei das erste und das zweite Ende des Kerns ein erstes bzw. ein zweites geflanschtes Ende (27, 28) aufweisen und das zweite geflanschte Ende (28) sich von dem Körper (12) aus ungefähr bis zu der Ebene erstreckt, die die Lötkissen (19) beinhaltet.

10. Induktive Komponente nach Anspruch 1, wobei das erste und das zweite Ende des Kerns ein erstes bzw. ein zweites geflanschtes Ende (27, 28) aufweisen und das erste geflanschte Ende (27) einen kleineren Durchmesser hat als das zweite geflanschte Ende (28).

11. Induktive Komponente nach Anspruch 10, wobei das erste geflanschte Ende (27) in de Öffnung (15) oberhalb des zweiten geflanschten Endes (28) vorgesehen ist.

12. Induktive Komponente nach Anspruch 10, wobei die induktive Komponente (10) eine Höhe von weniger als ungefähr 1,65 mm hat.

13. Induktive Komponente nach Anspruch 1, wobei die induktive Komponente (10) eine Höhe von weniger als ungefähr 1,65 mm hat.

14. Induktive Komponente nach Anspruch 1, wobei der Kern (25) einen mittleren Abschnitt (26) mit reduziertem Durchmesser hat, um welchen herum der Draht gewickelt ist, und wobei das erste und das zweite Ende des Kerns ein erstes bzw. zweites geflanschtes Ende (27, 28) aufweisen, wobei das erste geflanschte Ende (27) fest in die Öffnung (15) passt und das geflanschte Ende (28), das einen größeren Durchmesser hat als das erste geflanschte Ende (27), von der Oberfläche des Körpers (12) mittels Abstandshaltern (22) beabstandet ist, die sich von der unteren Oberfläche des Körpers (12) aus erstrecken.

15. Induktive Komponente nach Anspruch 12, wobei die Abstandshalter (22) eine solche Höhe haben, dass sie den zweiten Flansch (28) ungefähr eben mit der Ebene der Lötkissen (19) positionieren.

16. Induktive Komponente nach Anspruch 1, wobei der Körper (12) mit dem niedrigen Profil beabstandete Schenkel (18) hat, die sich von dem Körper aus um die Öffnung (15) herum erstrecken, wobei die Lötkissen (19) mit den Schenkeln (18) verbunden sind.

17. Induktive Komponente nach Anspruch 1, wobei der Körper (12) mit dem niedrigen Profil Schenkel (18) hat, die sich von dem Körper (12) aus erstrecken und an welchen die Lötkissen (19) angeschlossen sind.

18. Induktive Komponente nach Anspruch 17, wobei der Körper (12) mit dem niedrigen Profil eine polygonale Gestalt hat und eine Höhe von weniger als ungefähr 1,65 mm.

19. Verfahren zum Herstellen einer induktiven Komponente (10) mit niedrigem Profil, die an einer Platine (20) platzierbar ist, wobei das Verfahren folgendes aufweist:
Vorsehen eines Körpers (12) mit niedrigem Profil, an welchem beabstandete Lötkissen (19) angebracht sind und durch welchen hindurch sich eine Öffnung (15) erstreckt;
Vorsehen eines Kerns (25);
Wickeln eines Drahts (32) um den Kern (25) herum, um so ein erstes und ein zweites Ende (33) zu schaffen;
Einsetzen zumindest eines Bereichs des Kerns (25) in die Öffnung (15) hinein; und
elektrisches Verbinden der Drahtenden (33) mit jeweiligen Lötkissen (19) an dem Körper (12).

20. Verfahren nach Anspruch 19, wobei das Vorsehen eines Körpers (12) mit einem niedrigen Profil das Vorsehen eines Körpers (12) mit einem niedrigen Profil und beabstandeten Schenkeln (18) aufweist, mit welchen die Lötkissen (19) verbunden werden.

21. Verfahren zum Anbringen einer induktiven Komponente (10) mit niedrigem Profil an einer Platine (20), mit den folgenden Schritten:
Vorsehen eines Körpers (12) mit niedrigem Profil, wobei sich beabstandete Lötkissen (19) von dem Körper (12) aus erstrecken und wobei sich eine Öffnung (15) durch den Körper (12) hindurch zwischen den Lötkissen (19) erstreckt;
Vorsehen eines Kerns (25) mit einem ersten und einem zweiten Endbereich (27, 28), wobei zumindest ein Bereich des Kerns in der Öffnung (15) vorgesehen ist;
Vorsehen eines Drahts (32), der um den Kern (25) herumgewickelt ist und ein erstes und ein zweites Ende (33) hat, die mit jeweiligen Lötkissen (19) verbunden sind;
Einsetzen der induktiven Komponente (10) mit dem niedrigen Profil an der Platine (20) so, dass die Lötkissen (19) gegen Flächen auf der Platine (20) anliegen; und
Verlöten der induktiven Komponente (10) mit dem niedrigen Profil mit diesen Flächen, um die Komponente (10) elektrisch und mechanisch an der Platine (20) anzubringen.

22. Verfahren nach Anspruch 21, wobei sich eines der Enden (27, 28) des Kerns von dem Körper (12) zwischen den Lötkissen (19) erstreckt, und weiter mit dem Schritt des Einsetzens des sich erstreckenden Kernendes (27, 28) in eine Öffnung (42) in der Platine (20).

23. Verfahren nach Anspruch 22, wobei das Einsetzen des sich erstreckenden Endes des Kerns (27, 28) in die Öffnung (42) hinein das Erstrecken des Kernendes (27, 28) in die Öffnung (42) hinein um einen Betrag aufweist, der nicht größer ist als die Dicke der Platine (20).

## Revendications

1. Composant inductif (10) pour le montage sur une carte de circuits imprimés (20), comprenant :
un corps à profil bas (12) comportant des zones de soudure mutuellement espacées (19) connectées à celui-ci pour fixer électriquement et mécaniquement ledit corps (12) à des pistes sur une carte de circuits imprimés (20), et définissant une ouverture (15) s'étendant à travers ledit corps (12) entre lesdites zones de soudure (19) ;
un coeur (25) comportant des première et deuxième extrémités, et comportant au moins une partie du coeur (25) disposée dans ladite ouverture (15) ; et
un fil (32) enroulé autour dudit coeur (25), comportant des première et deuxième extrémités (33) électriquement connectées à des zones de soudure respectives (19).

2. Composant inductif selon la revendication 1, dans lequel ledit coeur (25) est constitué par un matériau magnétique.

3. Composant inductif selon la revendication 1, dans lequel lesdites première et deuxième extrémités de coeur comprennent des première et deuxième extrémités à flasque (27, 28), respectivement, et ladite deuxième extrémité à flasque (28) s'étend à partir dudit corps (12) entre lesdites zones de soudure (19).

4. Composant inductif selon la revendication 1, dans lequel lesdites première et deuxième extrémités de coeur comprennent des première et deuxième extrémités à flasque (27, 28), respectivement, et ladite deuxième extrémité à flasque (28) s'étend à partir dudit corps (12) au-delà desdites zones de soudure (19).

5. Composant inductif selon la revendication 1, dans lequel lesdites première et deuxième extrémités de coeur comprennent des première et deuxième extrémités à flasque (27, 28), respectivement, et ladite deuxième extrémité à flasque (28) s'étend à partir dudit corps (12) sur une ampleur qui n'est pas supérieure à l'ampleur sur laquelle s'étendent lesdites zones de soudure (19) à partir dudit corps (12).

6. Composant inductif selon la revendication 1, dans lequel lesdites première et deuxième extrémités de coeur comprennent des première et deuxième extrémités à flasque (27, 28), respectivement, et ladite deuxième extrémité à flasque (28) s'étend à partir dudit corps (12) sur une ampleur supérieure à l'ampleur sur laquelle s'étendent lesdites zones de soudure (19) à partir dudit corps (12).

7. Composant inductif selon la revendication 6, dans lequel ladite deuxième extrémité à flasque (28) s'étend à partir dudit corps (12) et à l'intérieur d'une ouverture (42) dans la carte de circuits imprimés (20) sur une ampleur qui n'est pas supérieure à l'épaisseur de la carte de circuits imprimés (20).

8. Composant inductif selon la revendication 1, dans lequel lesdites première et deuxième extrémités de coeur comprennent des première et deuxième extrémités à flasque (27, 28), respectivement, et ladite première extrémité à flasque (27) est disposée dans ladite ouverture (15) dudit corps (12) de telle sorte que ladite première extrémité à flasque (27) et ledit corps (12) créent une surface supérieure globalement plane.

9. Composant inductif selon la revendication 1, dans lequel lesdites première et deuxième extrémités de coeur comprennent des première et deuxième extrémités à flasque (27, 28), respectivement, et ladite deuxième extrémité à flasque (28) s'étend à partir dudit corps (12) à peu près jusqu'au plan contenant lesdites zones de soudure (19).

10. Composant inductif selon la revendication 1, dans lequel lesdites première et deuxième extrémités de coeur comprennent des première et deuxième extrémités à flasque (27, 28), respectivement, et ladite première extrémité à flasque (27) a un diamètre inférieur à celui de ladite deuxième extrémité à flasque (28).

11. Composant inductif selon la revendication 10, dans lequel ladite première extrémité à flasque (27) est disposée dans ladite ouverture (15) au-dessus de ladite deuxième extrémité à flasque (28).

12. Composant inductif selon la revendication 10, dans lequel ledit composant inductif (10) a une hauteur inférieure à environ 1,65 mm.

13. Composant inductif selon la revendication 1, dans lequel ledit composant inductif (10) a une hauteur inférieure à environ 1,65 mm.

14. Composant inductif selon la revendication 1, dans lequel le coeur (25) comporte une section centrale de diamètre réduit (26) sur laquelle le fil est enroulé, lesdites première et deuxième extrémités de coeur comprennent des première et deuxième extrémités à flasque (27, 28), respectivement, dans lequel la première extrémité à flasque (27) s'adapte étroitement dans l'ouverture (15) et la deuxième extrémité à flasque (28), de diamètre supérieur à celui de la première extrémité à flasque (27), est espacée de la surface du corps (12) par des éléments d'espacement (22) s'étendant à partir de la surface inférieure dudit corps (12).

15. Composant inductif selon la revendication 12, dans lequel les éléments d'espacement (22) ont une hauteur permettant de positionner le deuxième flasque (28) de façon à peu près affleurante avec le plan des zones de soudure (19).

16. Composant inductif selon la revendication 1, dans lequel ledit corps à profil bas (12) comporte des pattes mutuellement espacées (18) s'étendant à partir dudit corps autour de ladite ouverture (15) ; et lesdites zones de soudure (19) sont connectées auxdites pattes (18).

17. Composant inductif selon la revendication 1, dans lequel ledit corps à profil bas (12) comporte des pattes (18) s'étendant à partir dudit corps (12) auxquelles sont connectées lesdites zones de soudure (19).

18. Composant inductif selon la revendication 17, dans lequel ledit corps à profil bas (12) est de forme polygonale et a une hauteur inférieure à environ 1,65 mm.

19. Procédé pour réaliser un composant inductif à profil bas (10) destiné à être disposé sur une carte de circuits imprimés (20), le procédé comprenant les étapes consistant à :
réaliser un corps à profil bas (12) comportant des zones de soudure mutuellement espacées (19) connectées à celui-ci et définir une ouverture (15) s'étendant à travers ledit corps (12) ;
réaliser un coeur (25) ;
enrouler un fil (32) autour dudit coeur (25) de façon à constituer des première et deuxième extrémités (33) ;
insérer au moins une partie dudit coeur (25) dans ladite ouverture (15) ; et
connecter électriquement lesdites extrémités de fil (33) à des zones de soudure respectives (19) sur ledit corps (12).

20. Procédé pour réaliser un composant inductif à profil bas (10) selon la revendication 19, dans lequel la réalisation d'un corps à profil bas (12) comprend la réalisation d'un corps à profil bas (12) comportant des pattes mutuellement espacées (18) auxquelles sont connectées les zones de soudure (19).

21. Procédé de montage d'un composant inductif à profil bas (10) sur une carte de circuits imprimés (20), comprenant les étapes consistant à :
réaliser un corps à profil bas (12) comportant des zones de soudure mutuellement espacées (19) s'étendant à partir dudit corps (12) et définir une ouverture (15) s'étendant à travers ledit corps (12) entre lesdites zones de soudure (19) ;
réaliser un coeur (25) comportant des première et deuxième parties d'extrémité (27, 28) et comportant au moins une partie du coeur disposée dans ladite ouverture (15) ;
disposer un fil (32) enroulé autour dudit coeur (25) et comportant des première et deuxième extrémités (33) connectées à des zones de soudure respectives (19) ;
insérer ledit composant inductif à profil bas (10) sur ladite carte de circuits imprimés (20) de telle sorte que lesdites zones de soudure (19) butent sur des pistes sur la carte de circuits imprimés (20) ; et
souder ledit composant inductif à profil bas (10) auxdites pistes pour fixer électriquement et mécaniquement ledit composant (10) à la carte de circuits imprimés (20).

22. Procédé selon la revendication 21, dans lequel l'une desdites extrémités de coeur (27, 28) s'étend à partir dudit corps (12) entre lesdites zones de soudure (19) et comprend de plus l'étape consistant à insérer l'extrémité de coeur étendue (27, 28) à l'intérieur d'une ouverture (42) dans ladite carte de circuits imprimés (20).

23. Procédé selon la revendication 22, dans lequel l'insertion de l'extrémité de coeur étendue (27, 28) à l'intérieur de l'ouverture (42) comprend l'extension de l'extrémité de coeur (27, 28) à l'intérieur de l'ouverture (42) sur une ampleur qui n'est pas supérieure à l'épaisseur de la carte de circuits imprimés (20).
